# EUROPEAN PATENT APPLICATION

(11) **EP 4 832 280 A1**
(43) Date of publication of application: **28.10.2026**
(21) Application number: 26173391.9
(22) Date of filing: 20.04.2026
(51) Int. Cl.: H02H 3/16, G01R 31/52, H02H 3/52

(54) **APPARATUS, SYSTEM, AND METHOD FOR DETECTING ALTERNATING CURRENT (AC) (AC)GROUND FAULTS IN A 3-PHASE HIGH POWER OFF-BOARD BATTERY CHARGER**

(30) Priority: 21.04.2025 US 202519184979
(71) Applicant: Transportation IP Holdings, LLC, Norwalk, CT 06851 (US)
(72) Inventor: BERA, Shaon Kanti, 560038 Bangalore (IN); RATADIYA, Sarit, 560017 Bangalore (IN); VERMA, Rajeev, 560048 Bangalore (IN)
(74) Representative: K&L Gates LLP

(57) **Abstract**

An alternating current (AC) ground monitoring apparatus includes a sense circuit that is configured to monitor the neutral to ground current of a transformer, measuring-it through a resistor to determine the fundamental component of the current spectrum. The apparatus also includes a comparator circuit configured to compare this value against a pre-programmed setpoint. **If** the sensed current exceeds this setpoint, a relay is energized to isolate the transformer from the load. The apparatus may include additional features such as a tripping circuit with the relay, and a control circuit that performs Fourier analysis to extract the fundamental component from the sensed current. The sense circuit may be configured to calculate a true RMS value of the fundamental component, with the frequency of this component typically ranging from 50 Hz to 60 Hz.

## Description

### DISCUSSION OF ART

High power off-board battery chargers or uninterruptable power supply (UPS) systems (e.g., for a vehicle) are generally systems that have a 3-phase alternating current (AC) supply which is converted to controlled direct current (DC) voltage using an active front end Insulated Gate Bipolar Transistor (IGBT) based converter. Loads such as a battery are fed with the controlled DC power obtained as output from the active front end IGBT based converter.

On the supply side, these systems have a transformer (delta-star) with the neutral connected to ground through a grounding resistor. On the DC side, there are loads and resistor-capacitor (RC) snubber circuits. These systems have a high frequency current that flows between the RC snubber circuit ground and the neutral of a utility transformer during normal operation. During a fault, the root-mean-square (RMS) value of the neutral to ground current reduces compared to the value in normal operation of the system. This makes the detection of AC side ground faults (low fault ohms) difficult.

High power off-board battery chargers or UPS systems have a requirement to continue operation without tripping during normal operation and even with higher AC line-to-ground fault ohms (in the order of 500 ohms). Due to the presence of common-mode voltages, there are excursions on the terminal to ground voltages of the battery / loads on the DC side beyond the original equipment manufacturer (OEM) designated limits which degrades battery health and leads to pre-mature failure of the batteries.

To mitigate this, the neutral of the star connected winding of a 3-phase utility transformer is grounded with a suitable neutral to ground resistor. Despite this, the terminal to ground voltages of the battery are sometimes higher than the desired OEM limit. Moreover, RC snubber circuits are also present to keep the terminal to ground voltage of the battery balanced under vehicle operating conditions. The RC snubbers also remain present even while a vehicle is connected to an off-board charger and act as a low impedance path to the common mode currents. Thus, the presence of the RC snubber circuits give rise to ground currents in healthy scenarios also. This ground current has a very minimal fundamental component but maximum switching harmonics.

In the event of low fault ohms (AC line-to-ground fault), snubber circuit ground current which was previously flowing mainly through the neutral in healthy operation now shifts to the fault ground location due to low impedance path of fault impedance and high frequency ground currents start looping between the snubber circuit ground and the fault ground. Only the fundamental component (low RMS value) ground component starts flowing through the neutral to ground resistor limited by (R_{NGR}+R_{fault}).

Due to the reduction of the current magnitude through the neutral to ground resistor (NGR) during a low AC line-to-ground fault, real hard ground faults are not easily detected by a fault monitoring system that is based on the neutral to ground current threshold. It may be desirable to provide systems and methods for detecting ground faults that differ from existing systems and methods.

### BRIEF DESCRIPTION

In one embodiment, an alternating current (AC) ground monitoring apparatus includes a sense circuit configured to monitor a neutral to ground current of a transformer through a resistor. The sense circuit is also configured to determine a value of a fundamental component of a current spectrum of the neutral to ground current. The apparatus further comprises a comparator circuit, coupled to the sense circuit, configured to compare the value of the fundamental component of the sensed current spectrum of the neutral to ground current with a setpoint, and to activate a tripping circuit to isolate the transformer from a load based on the fundamental component of the sensed current spectrum of the neutral to ground current exceeding the setpoint.

In another embodiment, an alternating current (AC) ground monitoring system includes a fault detection circuit; a resistor coupled to the fault detection circuit; and a tripping circuit coupled to the fault detection circuit. The fault detection circuit includes a sense circuit configured to monitor a neutral to ground current of a transformer with a neutral connection to ground through the resistor, and to determine a value of a fundamental component of a current spectrum of the neutral to ground current. The fault detection circuit also includes a comparator circuit, coupled to the sense circuit, configured to compare the value of the fundamental component of the sensed current spectrum of the neutral to ground current with a pre-programmed setpoint, and to energize the tripping circuit to isolate the transformer from a load based on the fundamental component of the sensed current spectrum of the neutral to ground current exceeding the pre-programmed setpoint.

In another embodiment, a method of detecting a ground fault includes monitoring a neutral to ground current of a transformer through a resistor. The method further includes determining a value of a fundamental component of a current spectrum of the neutral to ground current. The method further includes comparing the value of the fundamental component of the sensed current spectrum of the neutral to ground current with a setpoint. The method further includes isolating the transformer from a load based on the fundamental component of the sensed current spectrum of the neutral to ground current exceeding the setpoint.

### BRIEF DESCRIPTION OF THE DRAWINGS

The accompanying drawings, where like reference numerals refer to identical or functionally similar elements throughout the separate views, together with the detailed description below, are incorporated in and form part of the specification, and serve to further illustrate aspects of concepts that include the claimed disclosure and explain various principles and advantages of those aspects.

The apparatus, system, and method disclosed herein have been represented where appropriate by conventional symbols in the drawings, showing only those specific details that are pertinent to understanding the various aspects of the present disclosure so as not to obscure the disclosure with details that will be readily apparent to those of ordinary skill in the art having the benefit of the description herein.
FIG. 1 illustrates an AC ground monitoring system to monitor a neutral to ground current through a neutral to ground resistor, according to at least one aspect of the present disclosure.
FIG. 2 illustrates an AC ground monitoring system during a normal (healthy) system operation, according to at least one aspect of the present disclosure.
FIG. 3 illustrates an AC ground monitoring system during an AC side line-to-ground fault operation, according to at least one aspect of the present disclosure.
FIG. 4 illustrates a fault detection circuit and tripping circuit components of an AC ground monitoring system, according to at least one aspect of the present disclosure.
FIG. 5 illustrates a graph of the magnitude of the frequency of a pre-fault condition on the neutral to ground current, according to at least one aspect of the present disclosure.
FIG. 6 illustrates a graph of the magnitude of the frequency of a post-fault condition on the neutral to ground current, according to at least one aspect of the present disclosure.
FIG. 7 illustrates a method of detecting a ground fault, according to at least one aspect of the present disclosure.

### DETAILED DESCRIPTION

Aspects of the invention relate to detecting AC line-to-ground faults (low fault ohms) in systems where the presence of RC snubber circuits may cause a ground current to flow even in a normal operating scenario, e.g., by differentiating the fault current from the ground current. Various embodiments of circuits isolate the faulty equipment from the utility supply by sensing the neutral to ground current. In accordance with various embodiments, a neutral to ground resistance is selected to allow ground fault detection and simultaneously facilitate reduced snubber ground current in normal operating scenarios.

In one aspect, the present disclosure pertains to an enhanced ground fault detection system for power delivery systems (e.g., high-power off-board battery chargers or UPS systems) that normally convert a 3-phase AC supply to DC voltage using a converter. The converter may be an IGBT converter. These systems may include a neutral-grounded transformer and RC snubbers, which present challenges for AC ground fault detection due to high-frequency current flow in normal conditions. Aspects of the invention provide a way to accurately distinguish between normal ground currents and fault-induced currents, even when snubber circuits are present. In embodiments, a ground fault detection system may be configured to detect low-ohm ground faults, isolate faulty equipment by monitoring the neutral to ground current, and select a neutral to ground resistor optimized for fault detection while minimizing snubber ground currents during healthy operation.

This approach is distinct due to its continuous operation capability during high fault ohms without tripping and its ability to handle common-mode voltages without degrading battery life. The ground current typically has minimal fundamental components but significant switching harmonics, which can make fault detection difficult. Embodiments of the ground fault detection system address these challenges by shifting snubber ground current during a fault, allowing for fault detection while reducing risks to operators.

In an embodiment, a ground fault detection system includes a current transformer, a control circuit (e.g., microprocessor circuit) configured to determine a fundamental ground current component of a Fourier spectrum of a current through the current transformer, and a comparator circuit with a pre-programmed set value to trip a main circuit breaker, thereby isolating the system, based on an RMS value of the fundamental ground current component.

In one general aspect, the present disclosure pertains to a ground fault detection system for power delivery systems (e.g., high power off-board battery chargers or UPS systems). The ground fault detection system includes an active front end converter (e.g., IGBT based) configured to convert a 3-phase AC supply to a controlled DC voltage. A delta-star transformer includes a neutral connection to ground through a grounding resistor. RC snubber circuits are connected on the DC side to mitigate common-mode voltage excursions. A current transformer and fault detection subsystem is operative to monitor the neutral to ground current for variations indicative of ground faults, differentiate between normal operation ground current and fault-induced ground current by evaluating the Fourier spectrum of the current, calculate the true RMS value of the fundamental current component, and compare the calculated RMS value to a setpoint (e.g., a pre-programmed setpoint). The subsystem is further operative to energize a relay to isolate the system from utility supply when the calculated RMS exceeds the setpoint, indicative of a ground fault.

In another aspect, the fault detection subsystem is configured to detect ground faults characterized by low fault ohms that would otherwise remain undetected due to current flow alterations caused by the presence of snubber circuits. In one aspect, the resistance of the grounding resistor is selectively determined to allow for effective ground fault detection and minimization of snubber ground currents during normal operating conditions. In one aspect, the current transformer is configured to accommodate a large diameter of core balance to allow passage of all current cables, enabling detection of unbalanced current through vector sum of three-line currents without necessity for an expansive and bulky assembly.

In another aspect, the fault detection subsystem includes a comparator circuit programmed with a set value based on the neutral to ground current expected during fault conditions and the accuracy limit of the current transformer, and is configured to isolate the equipment from utility supply via tripping of the main utility circuit breaker upon the RMS value exceeding the set value.

In another general aspect, the present disclosure pertains to a method for protecting a power delivery system (e.g., a high power off-board battery charger or UPS system). The method includes monitoring a flow of high frequency current between a snubber ground and a transformer neutral during normal operation, analyzing the monitored current with respect to a Fourier spectrum to distinguish between ground current induced by regular operation and that caused by ground faults, determining the true RMS value of the fundamental component of the neutral to ground current, comparing the determined RMS value to a predetermined threshold value corresponding to fault conditions, and initiating a system trip to isolate the equipment of the power delivery system from a utility supply if the determined RMS value exceeds the threshold value. In one aspect, the method includes configuring the predetermined threshold value based on projected fault condition current magnitudes and the measurement accuracy of the monitoring equipment.

In embodiments, the ground fault monitoring system may be configured to protect equipment in case of AC ground faults. The fault is detected based on the ground current in the neutral path. The presence of snubber circuits causes a ground current to flow in a normal operation scenario, which is higher in RMS value than a fault scenario. The ground fault monitoring system differentiates a ground current due to fault from the ground current due to presence of snubbers which is a healthy ground current flowing scenario.

In embodiments, the sensed fault is used as the basis to trip the main circuit breaker and hence isolate electrically connected equipment. The control method may include sensing the neutral to ground current using a current transformer, and evaluating a Fourier spectrum of the current, e.g., evaluating a true RMS value of the fundamental component from the Fourier spectrum. This RMS value may be fed into a comparator circuit to be compared with a set value of the fundamental component indicative of the fault or no fault neutral to ground current.

The set value may be programmed inside the comparator circuit, based on the value of the fundamental component of the neutral to ground current that will flow in case of fault, and based on the accuracy limit of the current transformer. If the sensed value is higher than the set value, an output will be energized to turn on a relay. The relay contacts will then be used to trip/ open the main utility circuit breaker that will immediately isolate the equipment from the utility supply.

In embodiments, the ground fault detection method may provide independent detection of AC ground faults in an off-board charger system. The method may include independently detecting AC side ground faults, without depending on the fault detection mechanism inside the vehicle or having to isolate the charging equipment.

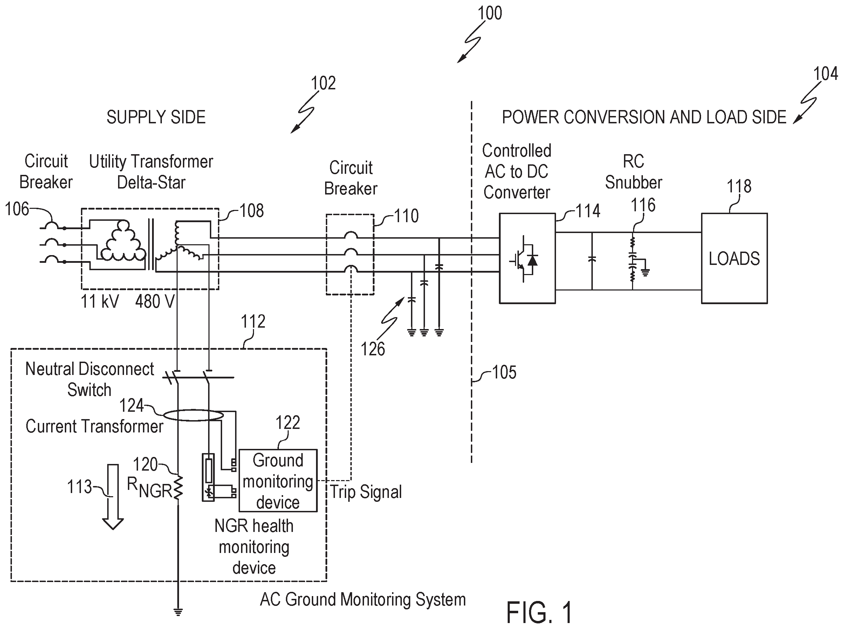

Turning now to the figures, FIG. 1 illustrates a battery charger 100 (e.g., a 3-phase high power offboard battery charger) including an AC ground fault monitoring system 112 configured to monitor a neutral to ground current 113 through a neutral to ground resistor 120 (R_{NGR}), according to at least one aspect of the present disclosure. The battery charger 100 includes a supply side 102 and a power conversion and load side 104 separated by the dashed line 105.

The supply side 102 includes a circuit breaker 110, a utility transformer 108 in a delta-star configuration, for example, a circuit breaker 110, and the AC ground fault monitoring system 112. The power conversion and load side 104 includes a controlled AC to DC converter 114, an RC snubber 116, and a load 118.

For example, the load side 104 is disposed on a vehicle with a battery. The battery may be charged by the supply side 102. The loads 118 may be battery loads. The load side may couple with a supply side 102 to charge the battery of the vehicle. In operation of the vehicle, the supply side is not coupled. In charging the vehicle, the supply side 102 is coupled to the vehicle and load side 104.

The load side comprises RC snubbers. The RC snubbers may be RC filters. The RC snubbers are configured to maintain the positive terminal to ground volage and the negative terminal to ground volage of the battery balanced under vehicle operating conditions, to prevent di-electric stress on the battery. As shown, the AC to DC converter receives three inputs, e.g. three phase power, and has one output, DC link voltage. The RC snubber maintains the positive terminal to ground volage and the negative terminal to ground voltage of the battery balanced under vehicle operating conditions, to prevent di-electric stress on the battery. The AC to DC converter converts the three-phase power to DC voltages.

The supply side 102 comprises a utility transformer 108 which is coupled to the circuit breaker 110 to isolate the supply side and the load side in case of a fault.

The AC ground fault monitoring system 112 includes the ground resistor (R_{NGR}) 120 and a ground monitoring device 122. A current transformer 124 monitors the neutral to ground current 113 through the R_{NGR} 120 and couples the sensed neutral to ground current 113 into the ground monitoring device 122. The ground monitoring device 122 generates a trip signal when it detects a ground fault to trip the circuit breaker 110 and disconnect the supply side 102 from the power conversion and load side 104. The cables exhibit cable stray capacitance 126.

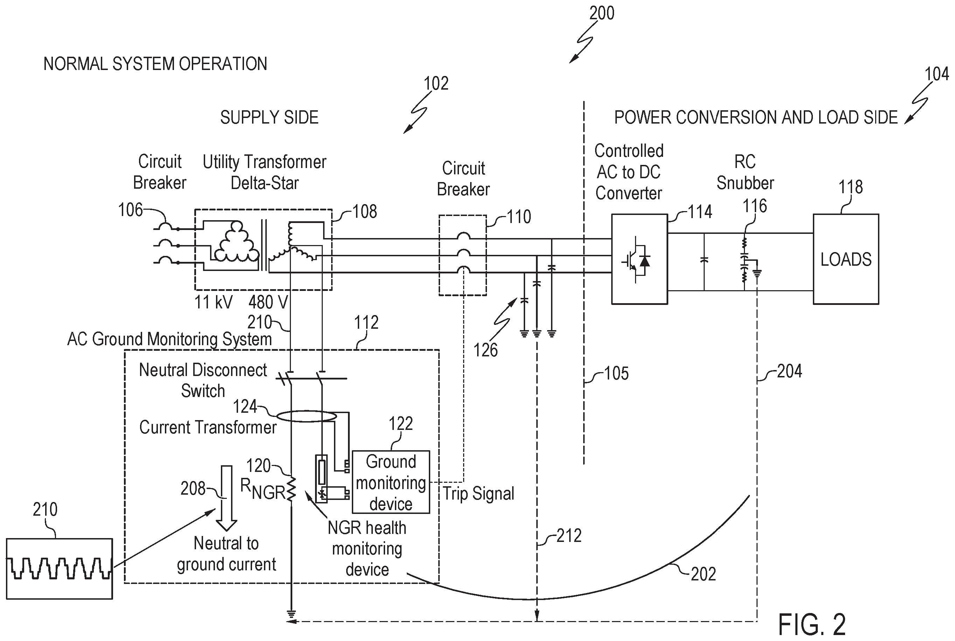

FIG. 2 illustrates the battery charger 200 during a normal system operation, according to at least one aspect of the present disclosure. During normal operation high frequency ground currents 202 are looping between snubber ground 204, cable stray capacitance 126, and the R_{NGR} 120. The majority of the neutral to ground current 208 flows through the RC snubber circuit through its ground 204 and only a low part of the current 212 flows through the cable stray capacitance 126 which is high in value (typically in the order of 100-200nF/phase to ground). Due to the above, the neutral to ground current 208 has a negligible fundamental component and contains mainly third harmonics and switching frequency and its multiples. An example neutral to ground current is shown in graph 210.

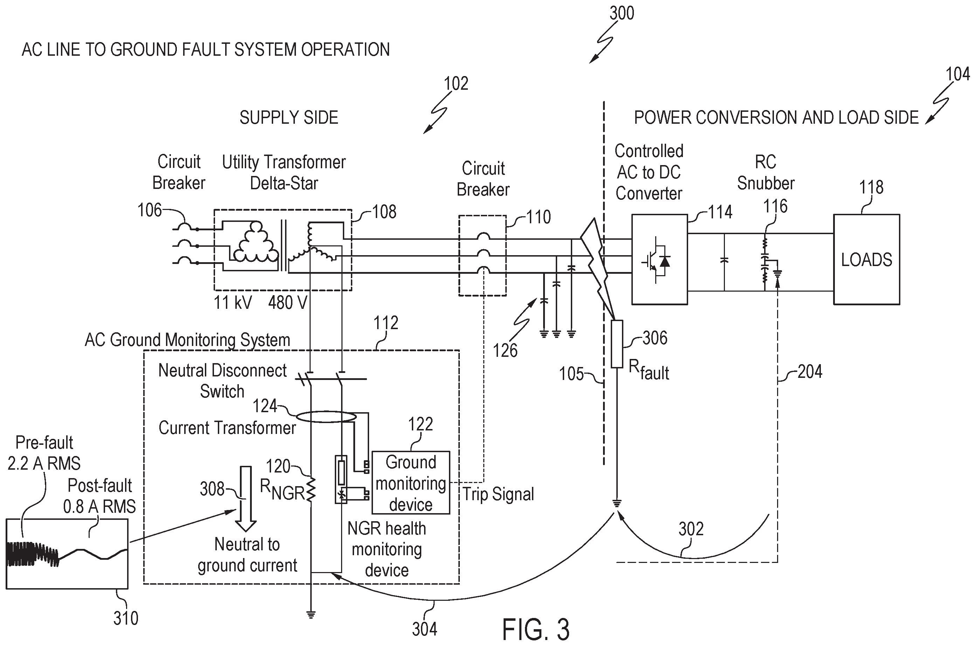

FIG. 3 illustrates the battery charger 300 during an AC line-to-ground fault system operation, according to at least one aspect of the present disclosure. During the AC line-to-ground fault system operation, the snubber ground current 302, which was flowing mainly through the neutral in normal operation, has now shifted to the fault ground location due to the low impedance path (lower R_{fault}). High frequency of higher RMS value ground currents 304 are looping between the snubber ground and the fault (R_{fault} 306). The fundamental component (low RMS value) ground current 308 component flows through the R_{NGR} 120 limited by the sum of R_{NGR} 120 and R_{fault} 306 (R_{NGR} + R_{fault}). As shown in the insert 310, the neutral to ground RMS current 308 pre fault 2.2 amperes (typical) with high frequency components reduces to 0.8 amperes (typical) post fault with mainly a fundamental component.

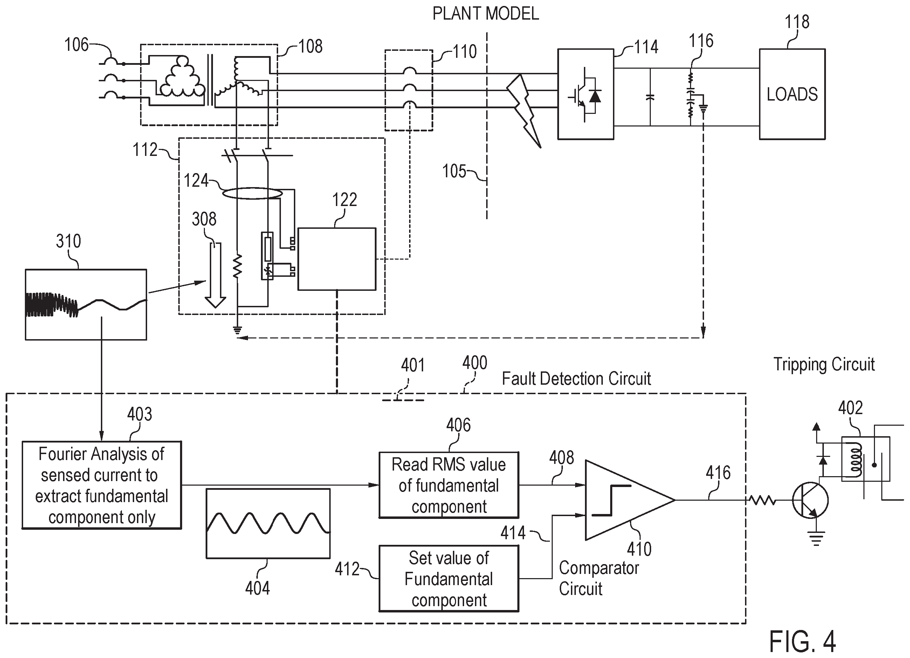

FIG. 4 illustrates a fault detection circuit 400 and tripping circuit 402 components of the ground monitoring device 122 of the AC ground monitoring system 112, according to at least one aspect of the present disclosure. The sensed neutral to ground current 308 through the R_{NGR} 120 is applied to the fault detection circuit 400. The fault detection circuit 400 performs 403 a Fourier analysis of the sensed neutral to ground current 308 to extract the fundamental component 404 only, as shown in the insert 310. The RMS value of the fundamental component 404 is read 406 and applied to one input 408 of a comparator circuit 410. A set value of the fundamental component 412 is applied to the other input 414 of the comparator circuit 410. When the sensed value of the neutral to ground current 308 is higher than the set value, the output 416 of the comparator circuit 410 energizes the tripping circuit 402 to trip the main circuit breaker 106 to disconnect the supply side 102 from the power conversion and load side 104.

The supply side may be coupled to the AC ground monitoring system through a snubber ground. The snubber ground may be coupled between the two RC snubbers of the load side and also to the neutral to ground resistor of the supply side.

The ground monitoring device 122 may be an alternating current (AC) ground monitoring apparatus. The ground monitoring device may comprise a sense circuit 401 configured to monitor a neutral to ground current of a transformer through a resistor 120. The sense circuit 401 is configured to determine a value of a fundamental component of a current spectrum of the neutral to ground current.

The ground monitoring device may also comprise a comparator circuit 410. The comparator circuit may be coupled to the sense circuit 401. The comparator circuit 410 may be configured to compare the value of the fundamental component of the current spectrum of the neutral to ground current with a setpoint 412. The comparator circuit 410 may activate a tripping circuit 402 to isolate the transformer from a load based on the fundamental component exceeding the setpoint.

The ground monitoring system 112 may comprise the ground monitoring device 122, a resistor 120 coupled to the fault detection circuit 400 and a tripping circuit 402 coupled to the fault detection circuit 400.

In some embodiments, the tripping circuit may include a relay coupled to the comparator circuit. The relay may open the circuit breaker to isolate the supply side from the load side.

In some embodiments, the sense circuit comprises a control circuit configured to execute a Fourier analysis of the neutral to ground current to extract the fundamental component of the current spectrum of the neutral to ground current. In some embodiments, a memory is coupled to the control circuit. The memory may store machine executable instructions that when executed by the control circuit cause the control circuit to execute the Fourier analysis.

In some embodiments, the sense circuit is configured to calculate a true root-mean-square (RMS) value of the fundamental component. The setpoint applied to the comparator circuit may also be a true RMS value.

The setpoint may be a pre-programmed setpoint stored in the memory coupled to the control circuit. The setpoint may be a dynamic setpoint based on the value of the resistor and the frequency of the operation.

In some embodiments, a frequency of the fundamental component is in a range of 50 Hz to 60 Hz.

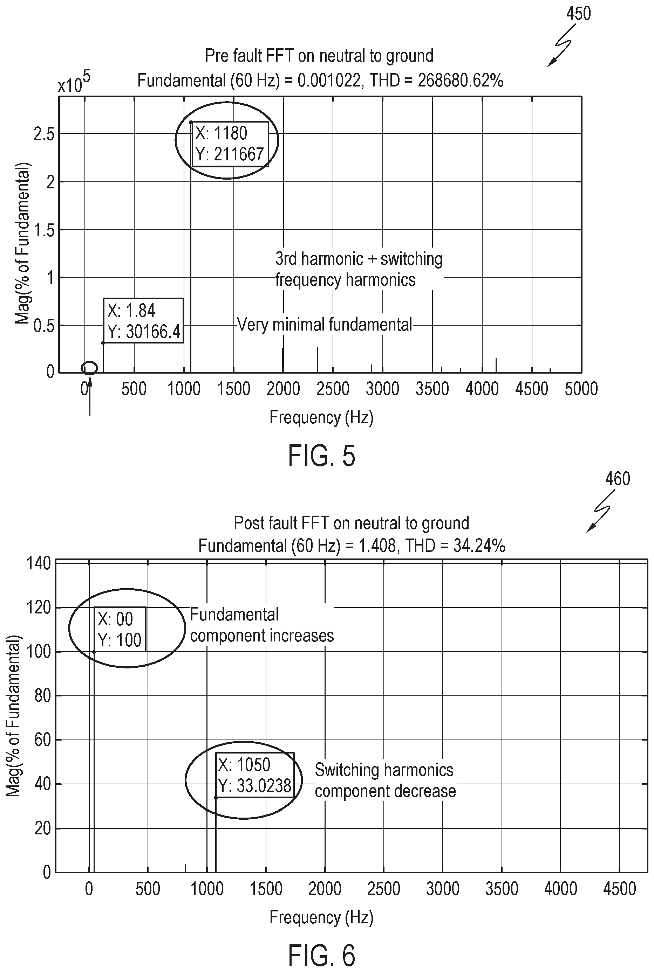

FIG. 5 illustrates a graph 450 of the magnitude of the frequency of a pre-fault condition on the neutral to ground current, according to at least one aspect of the present disclosure. The graph illustrates the magnitude of the frequency as a percentage of the fundamental frequency. This illustrates that there are very minimal fundamental frequencies at pre-fault conditions.

FIG. 6 illustrates a graph 460 of the magnitude of the frequency of a post-fault condition on the neutral to ground current, according to at least one aspect of the present disclosure. The graph illustrates the magnitude of the frequency as a percentage of the fundamental frequency. This illustrates that the fundamental component increases and the switching harmonics decreases at post-fault conditions.

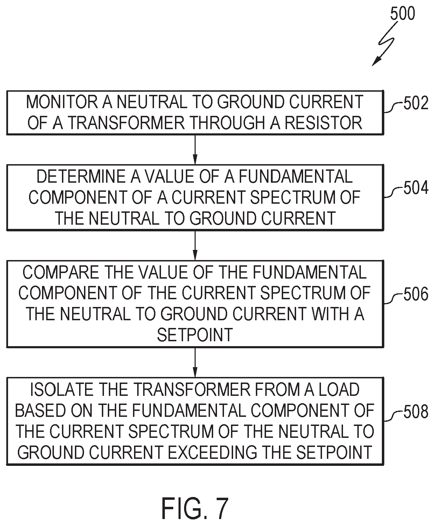

FIG. 7 illustrates a method of detecting a ground fault, according to at least one aspect of the present disclosure. The method may be implemented with any of the systems in FIGs. 1-4. In accordance with the method 500, monitor 502 a neutral to ground current of a transformer. The sense circuit 401 may monitor the neutral to ground current. The neutral to ground current may be monitored through the neutral to ground resistor.

In accordance with the method 500, determine 504 a value of a fundamental component of a current spectrum of the neutral to ground current. Determining the value of the fundamental component may include executing a Fourier analysis of the neutral to ground current. A control circuit may determine the fundamental component.

In accordance with the method 500, compare 506 the value of the fundamental component of the current spectrum of the neutral to ground current with a setpoint. A comparator circuit may be used to compare the value of the fundamental component with the setpoint. The output of the comparator circuit may be high when the value of the fundamental component is higher than the setpoint.

In accordance with the method 500, isolate 508 the transformer from a load based on the fundamental component of the current spectrum of the neutral to ground current exceeding the setpoint. Isolating the transformer may include energizing a relay to isolate the transformer. The relay may then trip a circuit breaker to isolate the load side from the supply side.

The method may include extracting the fundamental component of the current spectrum of the neutral to ground current. The setpoint may be a pre-programmed setpoint. The setpoint may be a dynamic setpoint. The setpoint may vary depending on the value of the neutral to ground resistor.

The method may include calculating a true root-mean-square (RMS) value of the fundamental component. The pre-programmed setpoint may then be a true RMS value.

The method may include configuring the pre-programmed setpoint based on a projected ground fault condition current magnitude. The projected ground fault condition current magnitude may be based on the neutral to ground resistor value and the frequency of operation.

The method may include differentiating between a normal operation ground current and a fault-induced ground current by evaluating the spectrum of the neutral to ground current. The spectrum may be a Fourier spectrum. To differentiate between the normal operation and a fault-inducted ground current, the control circuit may analyze the fundamental component, the switching harmonics, or a combination thereof.

The method may include coupling the neutral to ground current from the resistor to a sense circuit configured to monitor the neutral to ground current. The sense circuit may be a part of the ground monitoring device.

Examples of the devices, systems, and methods disclosed herein, according to various aspects of the present disclosure, are provided below in the following paragraphs. An aspect of the devices, systems, and methods may include any one or more than one, and any combination of, the elements described below.

In a first embodiment, an alternating current (AC) ground monitoring apparatus includes a sense circuit to monitor a neutral to ground current of a transformer through a resistor and determine a value of a fundamental component of a current spectrum of the neutral to ground current. The apparatus also includes a comparator circuit, coupled to the sense circuit, to compare the value of the fundamental component of the sensed current spectrum of the neutral to ground current with a setpoint and to isolate the transformer from a load based on the fundamental component exceeding the setpoint.

In one aspect of the first embodiment, the tripping circuit comprises a relay coupled to the comparator circuit.

In another aspect, in addition to or in combination with one or more than one aspect of the first embodiment, the sense circuit includes a control circuit to execute a Fourier analysis of the neutral to ground current to extract the fundamental component of the current spectrum of the neutral to ground current.

In another aspect, in addition to or in combination with one or more than one aspect of the first embodiment, the apparatus includes a memory coupled to the control circuit, wherein the memory stores machine executable instructions that when executed by the control circuit cause the control circuit to execute the Fourier analysis.

In another aspect, in addition to or in combination with one or more than one aspect of the first embodiment, the sense circuit is configured to calculate a true root-mean-square (RMS) value of the fundamental component and the setpoint applied to the comparator circuit is a true RMS value.

In another aspect, in addition to or in combination with one or more than one aspect of the first embodiment, a frequency of the fundamental component is in the range of 50 Hz - 60 Hz.

In a second embodiment, an alternating current (AC) ground monitoring system includes a fault detection circuit, a resistor coupled to the fault detection circuit, and a tripping circuit coupled to the fault detection circuit. The fault detection circuit includes a sense circuit to monitor a neutral to ground current of a transformer with a neutral connection to ground through the resistor and determine a value of a fundamental component of a current spectrum of the neutral to ground current. The fault detection circuit also includes a comparator circuit, coupled to the sense circuit, to compare the value of the fundamental component of the sensed current spectrum of the neutral to ground current with a pre-programmed setpoint and energize the tripping circuit to isolate the transformer from a load based on the fundamental component of the sensed current spectrum of the neutral to ground current exceeding the pre-programmed setpoint.

In one aspect of the second embodiment, the sense circuit comprises a control circuit to execute a Fourier analysis of the neutral to ground current that is monitored by the sense circuit to extract the fundamental component of the current spectrum of the neutral to ground current.

In another aspect, in addition to or in combination with one or more than one aspect of the second embodiment, the system includes a memory coupled to the control circuit, wherein the memory stores machine executable instructions that when executed by the control circuit cause the control circuit to execute the Fourier analysis.

In another aspect, in addition to or in combination with one or more than one aspect of the second embodiment, the sense circuit is configured to calculate a true root-mean-square (RMS) value of the fundamental component and the pre-programmed setpoint applied to the comparator circuit is a true RMS value.

In another aspect, in addition to or in combination with one or more than one aspect of the second embodiment, a frequency of the fundamental component is selected in the range of 50 Hz - 60 Hz.

In another aspect, in addition to or in combination with one or more than one aspect of the second embodiment, the system includes a current transformer coupled to the resistor to measure the neutral to ground current and coupled to the sense circuit.

In a third embodiment, a method of detecting a ground fault includes monitoring a neutral to ground current of a transformer through a resistor, determining a value of a fundamental component of a current spectrum of the neutral to ground current, comparing the value of the fundamental component of the sensed current spectrum of the neutral to ground current with a setpoint, and isolating the transformer from a load based on the fundamental component of the sensed current spectrum of the neutral to ground current exceeding the setpoint.

In one aspect of the third embodiment, isolating the transformer includes energizing a relay.

In another aspect, in addition to or in combination with one or more than one aspect of the third embodiment, determining the value of the fundamental component includes executing a Fourier analysis of the neutral to ground current.

In another aspect, in addition to or in combination with one or more than one aspect of the third embodiment, the setpoint is a pre-programmed setpoint.

In another aspect, in addition to or in combination with one or more than one aspect of the third embodiment, the method includes calculating a true root-mean-square (RMS) value of the fundamental component and the pre-programmed setpoint applied to the comparator circuit is a true RMS value.

In another aspect, in addition to or in combination with one or more than one aspect of the third embodiment, the method includes configuring the preprogrammed setpoint based on a projected ground fault condition current magnitude.

In another aspect, in addition to or in combination with one or more than one aspect of the third embodiment, the method includes differentiating between a normal operation ground current and a fault-induced ground current by evaluating the Fourier spectrum of the neutral to ground current.

In another aspect, in addition to or in combination with one or more than one aspect of the third embodiment, the method includes coupling the neutral to ground current from the resistor to a sense circuit configured to monitor the neutral to ground current.

Embodiments may be described in connection with a rail vehicle system, such as a locomotive or switcher, or other types of vehicle systems, such as automobiles, trucks (with or without trailers), buses, marine vessels, aircraft, unmanned aircraft (e.g., drones), mining vehicles, agricultural vehicles, or other off-highway vehicles. Vehicle systems described herein (rail vehicle systems or other vehicle systems that do not travel on rails or tracks) may be formed from a single vehicle or multiple vehicles. With respect to multi-vehicle systems, the vehicles may be mechanically coupled with each other (e.g., by couplers), or virtually or logically coupled but not mechanically coupled. For example, vehicles may be logically but not mechanically coupled when the separate vehicles communicate with each other to coordinate movements of the vehicles with each other so that the vehicles travel together (e.g., as a convoy, swarm, consist, platoon). Calculations and computations, such as navigation processes, may be performed on-board the vehicle systems or off-board the vehicle systems and then communicated to the vehicle systems. Whether on-board or off-board, a vehicle control system may operate a vehicle system and receive and process sensor inputs, operator inputs, operational parameters, vehicle parameters, and route parameters, etc.

The terms "control circuit" and "controller" are substitutable with each other and encompasses hardwired circuitry, programmable logic (such as microprocessors, microcontrollers, digital signal processors (DSPs), programmable logic devices (PLDs), programmable gate arrays (PGAs), or field-programmable gate arrays (FPGAs)), state machines, or firmware that executes stored instructions. Control circuits may form part of larger systems, such as integrated circuits (ICs), application-specific integrated circuits (ASICs), or systems-on-chips (SoCs), and may be found in devices such as computers, smartphones, wearable devices, and servers. These circuits may perform tasks involving data processing, communication, or data storage. Depicted components, functions, or operations may be implemented using hardware, software, firmware, or combinations of two or more thereof.

Instructions for implementing system features can be stored in various types of memory. Suitable memory may include dynamic random-access memory (DRAM), flash memory, and/or cache. These instructions can be distributed over a network or via other computer-readable media. The term "non-transitory computer-readable medium" refers to any physical medium capable of storing or transmitting instructions or information that can be read by a machine. Examples of suitable media include RAM, ROM, EPROM, EEPROM, magnetic or optical media, flash memory, or even propagated signals such as carrier waves or infrared signals.

In some embodiments, the control circuit can utilize machine learning (ML) techniques to make decisions based on sensor inputs or other data. Suitable ML methods may include supervised learning (with labeled inputs and outputs), unsupervised learning (for identifying patterns), or reinforcement learning (where the system adapts based on feedback). Suitable tasks for ML systems may involve classification, regression, clustering, anomaly detection, or optimization. ML may employ algorithms, such as decision trees, deep learning, support vector machines (SVMs), or neural networks, depending on the application. A suitable control circuit may incorporate a policy engine that applies specific rules based on equipment characteristics or environmental conditions. For instance, a neural network could process sensor data or operational inputs to determine appropriate actions. Techniques such as backpropagation or evolutionary strategies may be used to refine neural network parameters and optimize model selection for the given task.

In one embodiment, the control circuit (or controller) and system described herein may use machine learning to make determinations and to enable derivation-based learning outcomes. The system may communicate with a data collection system. The control circuit may learn from, model and make decisions/determinations on a set of data (including data provided by various sensors and data collection systems) by making data-driven predictions and adapting according to available data and modeling. Machine learning may involve performing tasks using supervised learning, unsupervised learning, and reinforcement learning systems. Supervised learning may use a set of example inputs and desired outputs to the machine learning systems, where unsupervised learning may use a learning algorithm that is structuring its input with, e.g., pattern detection and/or feature learning. Reinforcement learning may perform in a dynamic environment and then provide feedback about correct and incorrect decisions. Machine learning may include tasks based on certain outputs. These tasks may be machine learning problems such as classification, regression, clustering, density estimation, dimensionality reduction, anomaly detection, and the like to include other mathematical and statistical techniques. Suitable machine learning algorithmic types may include decision tree based learning, association rule learning, deep learning, artificial neural networks, genetic learning algorithms, inductive logic programming, support vector machines (SVMs), Bayesian network, reinforcement learning, representation learning, rule-based machine learning, sparse dictionary learning, similarity and metric learning, learning classifier systems (LCS), logistic regression, random forest, K-Means, gradient boost, K-nearest neighbors (KNN), a priori algorithms, and the like. In embodiments, certain machine learning algorithms may be used (e.g., for solving both constrained and unconstrained optimization problems that may be based on natural selection). In an example, the algorithm may be used to address problems of mixed integer programming, where some components restricted to being integer-valued. Algorithms and machine learning techniques and systems may be used in computational intelligence systems, computer vision, Natural Language Processing (NLP), recommender systems, reinforcement learning, building graphical models, and the like. In an example, machine learning may be used for making determinations, calculations, comparisons and behavior analytics, and the like.

As mentioned above, the control circuit may include a policy engine. The policies the engine may apply can be based at least in part on characteristics of a given item of equipment or environment. For example, an artificial intelligence system, such as a neural network, can receive input of a number of environmental and task-related parameters. These parameters may include, for example, operational input of the given equipment, data from various sensors, environmental information, location and/or position data, and the like. The neural network can be trained and can generate an output based on these inputs, with the output representing an action or sequence of actions that the equipment or system should take to accomplish the goal of the operation. The control circuit can process the inputs through the parameters of the neural network to generate a value (i.e., make a determination) at the output node designating that action as the desired action, activity, or operating state. An action may translate into a signal that causes the vehicle to operate in a particular manner. The control circuit may accomplish this via back-propagation, feed forward processes, closed loop feedback, or open loop feedback, for example. Alternatively, rather than using backpropagation, the control circuit may use evolution strategies techniques to tune various parameters of the neural network. The control circuit may use neural network architectures that have a set of parameters representing weights of its node connections. A number of copies of this network can be generated and adjustments to the parameters can be made with subsequent simulations. Once the outputs from the various models have been obtained, they may be evaluated on their performance using a determined success metric. The best model or a good-enough model may be selected, and the control circuit can execute that plan to achieve the desired input data to mirror the predicted 'best outcome' scenario. Additionally, the success metric itself may be a combination of the optimized outcomes, which may be weighed relative to each other. Success metrics may be dynamically established, and the process rerun and the equipment directions further modified.

In one embodiment, data can be generated, transmitted, and stored and may involve one or both of a protected space data source and the exposed space data source. The control circuit may encrypt and decrypt data as needed at rest, during use, or in transit. Encryption keys and schema may be selected and implemented as informed by end use parameters and requirements. The control circuit may evaluate and/or identify a decision boundary (that is, a boundary that separates desired behavior from undesired behavior) with regard to that data. If the control circuit determines that some quantity of data is from a protected space data source and/or is operating within determined boundaries then the control circuit, and the equipment being controlled, may operate normally. However, if the data is determined to be from an exposed space data source and/or it crosses the decision boundary, the control circuit may respond. Suitable responses may be to power down determined equipment, signal an alert, run a diagnostic routine, perform a data backup (without overwriting existing backup data), isolate equipment (including by suspending some or all communication pathways), switch equipment or control operations to a safe mode of the control system, and/or initiate a safe mode state of the equipment (e.g., slow a vehicle to a safe and controlled stop). The safe mode may be, in one embodiment, a soft shutdown mode that it intended to avoid damage or injury based on the shutdown itself and in another embodiment may be a reboot and/or minimal reload of essential drivers and functionality.

In one embodiment, vehicle systems may implement secure authentication processes, encryption protocols, and firewalls to protect against unauthorized access or spoofing. A suitable control circuit may include a security module responsible for detecting and responding to suspicious activities, such as unapproved data access attempts or irregular communication patterns. This module may employ machine learning to adapt its defense strategies, learning from previous attacks and adjusting security measures as needed to prevent similar breaches.

In certain embodiments, maintenance and diagnostic functions may be integrated into the control circuit, enabling the system to self-monitor for operational health. The control circuit may utilize diagnostic algorithms to assess the status of various vehicle components, such as engines, brakes, batteries, fuel cells and fuel systems, propulsion systems, and electronic systems (if present). If a component is found to be underperforming or at risk of failure, the control circuit may schedule alerts, recommend maintenance, or initiate safety protocols to avoid catastrophic failure. Self-diagnostics may use historical performance data to identify trends, facilitating proactive rather than reactive maintenance.

Terms such as "processing," "computing," "calculating," or "determining" refer to operations carried out by the control circuit, which may include computing systems or electronic devices that manipulate data represented as physical (electronic) quantities within memory or registers. One or more components may be described as "configured to," "configurable to," "operable/operative to," "adapted/adaptable to," or similar terms. Unless explicitly stated, these terms encompass components in both active and inactive states. Unless stated otherwise, terms like "including" or "having" should be interpreted as open-ended (i.e., "including but not limited to"). Numeric claim recitations generally mean "at least" the stated number, and disjunctive terms like "A or B" should be interpreted to include either or both unless explicitly specified. Operations in any claim may generally be performed in any order unless explicitly stated. The recitation "at least one of A, B, and C" should be interpreted as any combination of A, B, and C, such A alone, B alone, C alone, A and B together, A and C together, B and C together, and/or A, B, and C together. The recitation "at least one of A, B, or C" should be interpreted to include A alone, B alone, C alone, A and B together, A and C together, B and C together, and/or A, B, and C together.

This written description may disclose several embodiments of the subject matter, including the best mode, and may enable one of ordinary skill in the relevant art to practice the embodiments of subject matter, including making and using any devices or systems and performing any incorporated methods. The patentable scope of the subject matter is defined by the claims, and may include other embodiments that may occur to one of ordinary skill in the art. Such other embodiments may be intended to be within the scope of the claims if they may have structural elements that may not differ from the literal language of the claims, or if they may include equivalent structural elements with insubstantial differences from the literal languages of the claims.

## Claims

1. An alternating current (AC) ground monitoring apparatus comprising:
a sense circuit configured to monitor a neutral to ground current of a transformer through a resistor and determine a value of a fundamental component of a current spectrum of the neutral to ground current; and
a comparator circuit, coupled to the sense circuit, configured to compare the value of the fundamental component of the current spectrum of the neutral to ground current with a setpoint and activate a tripping circuit to isolate the transformer from a load based on the fundamental component exceeding the setpoint.

2. The apparatus of claim 1, wherein the tripping circuit comprises a relay coupled to the comparator circuit.

3. The apparatus of claim 1, wherein the sense circuit comprises a control circuit configured to execute a Fourier analysis of the neutral to ground current to extract the fundamental component of the current spectrum of the neutral to ground current.

4. The apparatus of claim 3, comprising a memory coupled to the control circuit, wherein the memory stores machine executable instructions that when executed by the control circuit cause the control circuit to execute the Fourier analysis.

5. The apparatus of claim 1, wherein the sense circuit is configured to calculate a true root-mean-square (RMS) value of the fundamental component and the setpoint applied to the comparator circuit is a true RMS value.

6. The apparatus of claim 1, wherein a frequency of the fundamental component is in a range of 50 Hz - 60 Hz.

7. An alternating current (AC) ground monitoring system comprising:
a fault detection circuit;
a resistor coupled to the fault detection circuit; and
a tripping circuit coupled to the fault detection circuit;
wherein the fault detection circuit comprises:
a sense circuit configured to monitor a neutral to ground current of a transformer with a neutral connection to ground through the resistor and determine a value of a fundamental component of a current spectrum of the neutral to ground current; and
a comparator circuit, coupled to the sense circuit, configured to compare the value of the fundamental component of the current spectrum of the neutral to ground current with a pre-programmed setpoint and energize the tripping circuit to isolate the transformer from a load based on the fundamental component of the current spectrum of the neutral to ground current exceeding the pre-programmed setpoint.

8. The system of claim 7, wherein the sense circuit comprises a control circuit configured to execute a Fourier analysis of the neutral to ground current that is monitored by the sense circuit to extract the fundamental component of the current spectrum of the neutral to ground current.

9. The system of claim 8, comprising a memory coupled to the control circuit, wherein the memory stores machine executable instructions that when executed by the control circuit cause the control circuit to execute the Fourier analysis.

10. The system of claim 7, wherein the sense circuit is configured to calculate a true root-mean-square (RMS) value of the fundamental component and the pre-programmed setpoint applied to the comparator circuit is a true RMS value.

11. The system of claim 7, wherein a frequency of the fundamental component is selected in a range of 50 Hz - 60 Hz.

12. The system of claim 7, comprising a current transformer coupled to the resistor to measure the neutral to ground current and coupled to the sense circuit.

13. A method of detecting a ground fault, the method comprising:
monitoring a neutral to ground current of a transformer through a resistor;
determining a value of a fundamental component of a current spectrum of the neutral to ground current;
comparing the value of the fundamental component of the current spectrum of the neutral to ground current with a setpoint; and
isolating the transformer from a load based on the fundamental component of the current spectrum of the neutral to ground current exceeding the setpoint.

14. The method of claim 13, wherein isolating the transformer comprises energizing a relay.

15. The method of claim 13, wherein determining the value of the fundamental component comprises executing a Fourier analysis of the neutral to ground current.

16. The method of claim 13, wherein the setpoint is a pre-programmed setpoint.

17. The method of claim 16, comprising calculating a true root-mean-square (RMS) value of the fundamental component, wherein the pre-programmed setpoint is a true RMS value.

18. The method of claim 17, comprising configuring the pre-programmed setpoint based on a projected ground fault condition current magnitude.

19. The method of claim 13, comprising differentiating between a normal operation ground current and a fault-induced ground current by evaluating the spectrum of the neutral to ground current.

20. The method of claim 13, comprising coupling the neutral to ground current from the resistor to a sense circuit configured to monitor the neutral to ground current.
